# EUROPEAN PATENT APPLICATION

(11) **EP 1 253 635 A1**
(43) Date of publication of application: **30.10.2002**
(21) Application number: 01830267.9
(22) Date of filing: 23.04.2001
(51) Int. Cl.: H01L 21/8247, H01L 21/336

(54) **Method for sealing a memory device**

(71) Applicant: STMicroelectronics S.r.l., 20041 Agrate Brianza (Milano) (IT)
(72) Inventor: Crivelli, Barbara, 20155 Milano (IT); Alessandri, Mauro, 20059 Vimercate Mi (IT); Servalli, Giorgio, 24020 Ciserano BG (IT); Maurelli, Alfonso, 20050 Sulbiate Mi (IT)
(74) Representative: Mittler, Enrico

(57) **Abstract**

The present invention relates to a method for sealing a nonvolatile memory device, characterized in that to comprise the following steps of: a) defining a nonvolatile memory cell (20), being composed by the overlap of a tunnel oxide (3), of a floating gate (1), of an interpoly dielectric (2), and of a control gate (4); b) deposing a silicon oxide layer (11) by a CVD (Chemical Vapor Deposition) at a temperature lower than 1000 °C on said control gate (4); c) densifing said silicon oxide layer (11) by a further thermal treatment (13). (Figure 5).

## Description

The present invention relates to a method for sealing a memory device, particularly for a nonvolatile memory device.

It is known that a sealing process, also called re- oxidation, guarantees the isolation of the nonvolatile memory device toward outside.

The sealing process also guarantees, in the case of nonvolatile memory device, the retention of the stored voltage level.

It is also known that a sealing process of a cell, implemented in a nonvolatile memory device, shows at least three different problems: 1) as technology continues to progress and as the level of integration for integrated circuits is increased, there is the need of a higher scaling of the device dimensions and an analogous decrease of the thermal budgets, relating to the process steps made at high temperature; 2) the direct exposition of particularly stressed silicon surfaces to the oxygen is able to activate possible defects previously formed in the inner substrate; 3) the integration in the embedded memories of the control logic and of the cell arrays.

Referring to previous point 1, due to a scaling of the device dimensions, it is necessary to reduce the dimensions of the doped silicon zones. In fact, it is necessary to limit the lateral diffusion of the dopants in said doped silicon zones. Therefore, due to limit the dopant lateral diffusion, it is necessary to reduce the thermal budget of the treatments, such as the re-oxidation, implemented after the definition of the junctions of the nonvolatile cell.

Referring to the previous point 2, the re - oxidation processes, according to the prior art, are implemented by a thermal oxidation at high temperature, for example higher than 900 °C.

It is known to a skilled person that to bring the wafers, wherein are obtained the nonvolatile memory devices, to higher temperature than 800 °C, without causing defects on the silicon surface, it is necessary to introduce, during the ramp - up phase, an oxygen gas.

This oxygen gas, that is able to prevent the damages of the silicon surface, however, activates the defects of the silicon substrate.

Referring to the previous point 3, in the embedded memories the control logic requires an extremely fine re - oxidation process, implemented by means of a reduced thermal budget, whereas the nonvolatile memories require a sufficiently thick and better quality re - oxidation, so as to guarantee the retention characteristics of the memory device.

In fact, for the embedded memory then, a re - oxidation layer thicker than 50 Å (i.e. high temperature process for long time) is absolutely necessary.

However the integration of such a process is not compatible with the thermal budget sustainable by the control logic.

In view of the state of the art described, it is in object of the present invention provide a lower overall temperature re - oxidation process preventing the exposition of silicon surfaces to the oxygen.

It is also in object of the present invention provide a new sealing process that guarantees the correct working parameters, such as the threshold voltage value of the charge retention characteristics, the transistor current in working condition, the leakage current, etc. of the next generations of devices.

According to the present invention, such object is attained by a method for sealing a nonvolatile memory device, characterized in that to comprise the following steps of: a) defining a nonvolatile memory cell, being composed by the overlap of a tunnel oxide, of a floating gate, of an interpoly dielectric, and of a control gate; b) deposing a silicon oxide layer by a CVD (Chemical Vapor Deposition) at a temperature lower than 1000 °C on said control gate; c) densifing said silicon oxide layer by a further thermal treatment.

Thanks to the present invention it is possible to form a sealing of a nonvolatile memory cell by means of sealing process obtained with a lower thermal budget process.

Thanks to the present invention it is also possible to form a perfect sealing of the silicon surface, without exposing it to oxygen at temperatures higher than 800 °C.

Moreover using the new sealing process a better control of the re-oxidation thickness on all the different zone of the device can be achieved with respect to conventional technique.

The features and the advantages of the present invention will be made evident by the following detailed description of one its particular embodiment, illustrated as not limiting example in the annexed drawings, wherein:
Figure 1 shows a nonvolatile memory cell obtained by means of a sealing process according to the prior art;
Figures 2 - 5 show a sequence of a sealing process of the nonvolatile memory cell according to the present invention;
Figure 6 shows a nonvolatile memory cell obtained by means of the sealing process according to the present invention.

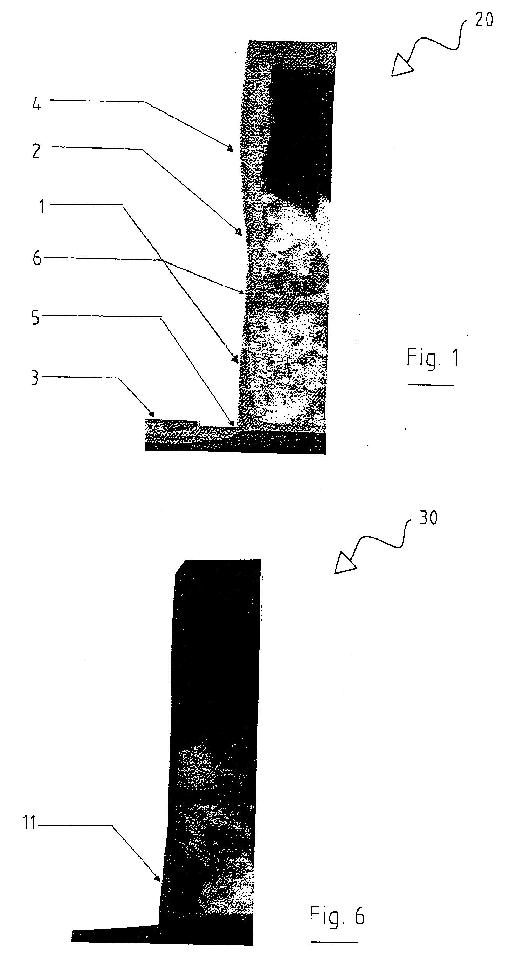

As Figure 1 shows, a sealing process of a cell implemented by means of a thermal re - oxidation acts in a different way on the various substrates, such as diversely doped silicon, polysilicon WSi₂ etc., exposed to the oxidant agents.

In fact in Figure 1, it is possible to note, that this selectivity of the sealing process, causes oxide thicknesses different from the distinct parts of the device.

Particularly in Figure 1, a cross sectional view of a nonvolatile memory 10 is shown, and it is possible to note that in a first part 1, identifiable as a floating gate, and in a second part 2, identifiable as an interpoly dielectric, the thickness of the oxide is about 100 - 300 Å.

Moreover it is possible to note that in a third part 3, identifiable as a tunnel oxide, and in a fourth part 4, identifiable as a control gate, the thickness of the oxide is about 200 - 500 Å.

Moreover a such sealing process causes some narrowing 5 and 6 where the active dielectrics are implemented, that is in proximity respectively of the tunnel oxide 3 and dielectric interpoly 2.

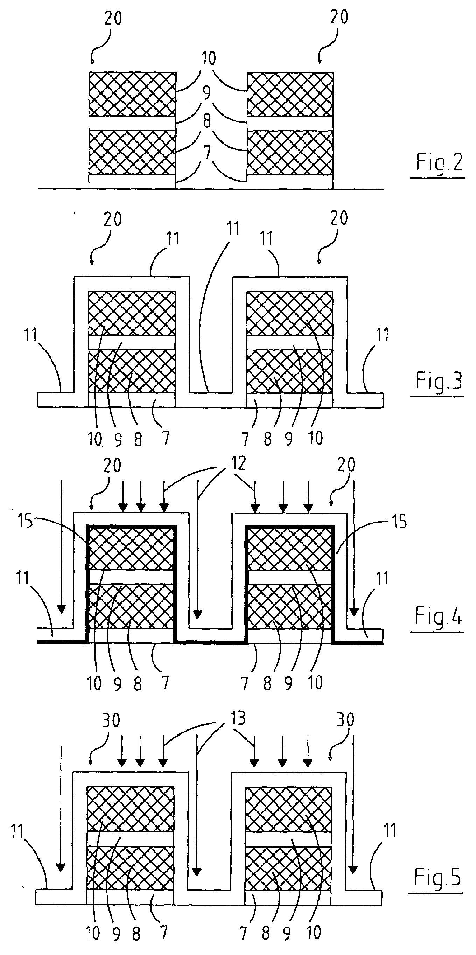

On the contrary the new sealing process, implemented by an oxide densified by a Chemical Vapor Deposition (CVD), opportunely modified, produces an silicon oxide layer more uniform with respect to the prior art, as shown in the sequence of Figures 2 - 5.

Wherever possible, the same reference numbers are used in the sequence of Figures 2 - 5 and the description to refer to the same or like parts.

Particularly, in Figure 2, the first step of the innovative process is the definition of the nonvolatile memory cell, that is, there is the definition of a tunnel oxide 7, of the floating gate 8, of the interpoly dielectric 9 and of the control gate 10.

At this step, control logic transistors can eventually be already defined too.

Particularly, in Figure 3, the second step of the innovative process is the deposition of an oxide layer 11 by means of CVD technique in batch o single wafer systems, made by at a temperature lower than 1000 °C.

The innovative process is completely defined by an eventual nitridation phase and an obligatory densification phase, as heretofore described.

In fact, in Figure 4, the third step of the innovative process is the nitridation (depicted as a plurality of vertical arrows 12) of said deposed silicon oxide layer 11 in batch or single wafer systems by means of NH₃, N₂O, NO gases or plasma assisted nitridation.

The nitridation phase involves the incorporation of nitrogen gas in all the possible interfaces such as SiO₂ / Si or SiO₂ / poly, as depicted in figure 4 with the line 15.

By the way this third step can be an optional step of the inventive process.

Particularly, in Figure 5, the fourth step of the innovative process is the densification (depicted as a plurality of vertical arrows 13) of said deposed silicon oxide layer 11 in batch or single wafer systems by a next treatment, for example a thermal treatment in inert atmosphere, such as N₂, or by a thermal treatment in oxidant atmosphere, such as H₂O or O₂.

Due to presence of the CVD oxide layer, the densification step can be executed by using low temperature process, such as 800 °C for some hours, or higher temperature treatment for shorter time.

In this way the new sealing process, implemented by the oxide 11 obtained by a CVD technique, forms a sealing of a nonvolatile memory cell 30 with an overall lower thermal budget, and no exposure of the silicon surface at oxygen at a temperature higher than 800 °C.

Moreover the new sealing process forms a perfect sealing of the silicon surface of the nonvolatile memory cell 30, as shown in the cross sectional view of Figure 6.

In Figure 6 the sealing process of a nonvolatile cell according to the present invention is shown, wherein it is to be noted the thickness uniformity of the silicon oxide layer 11.

In fact the Applicant has found that the thickness of the silicon oxide layer 11, deposed around the perimeter of said nonvolatile memory cell 30, is about 100 - 300 Å.

Further it is possible to note that the narrowing 5 and 6 are completely deleted by the innovative sealing process.

## Claims

1. Method for sealing a nonvolatile memory device, **characterized in that** to comprise the following steps of:
a) defining a nonvolatile memory cell (20), being composed by the overlap of a tunnel oxide (3), of a floating gate (1), of an interpoly dielectric (2), and of a control gate (4);
b) deposing a silicon oxide layer (11) by a CVD (Chemical Vapor Deposition) at a temperature lower than 1000 °C on said control gate (4);
c) densifing said silicon oxide layer (11) by a further thermal treatment (13).

2. Method for sealing a memory device according claim 1, **characterized by** the fact said step (c) is made by means of oxidant atmosphere treatment (13).

3. Method for sealing a memory device according claim 1, **characterized by** the fact said step (c) is made by means of an inert atmosphere treatment (13).

4. Method for sealing a memory device according claim 1, **characterized by** the fact to comprise further a step of nitridation (12) of said silicon oxide layer (11) by means of a NH₃ gas.

5. Method for sealing a memory device according claim 1, **characterized by** the fact that said step (b) is made at a temperature of about 800 °C.

6. Method for sealing a memory device according claim 4, **characterized by** the fact that said step of nitridation (12) of said silicon oxide layer (11) is made by means of a N₂O gas.

7. Method for sealing a memory device according claim 4, **characterized by** the fact that said step of nitridation (12) of said silicon oxide layer (11) is made by means of a NO gas.

8. Method for sealing a memory device according claim 4, **characterized by** the fact that said step of nitridation (12) of said silicon oxide layer (11) is made by means of plasma assisted nitridation.

9. Method for sealing a memory device according claim 2, **characterized by** the fact said oxidant atmosphere treatment (13) is made by H₂O gas.

10. Method for sealing a memory device according claim 2, **characterized by** the fact said oxidant atmosphere treatment (13) is made by O₂ gas.

11. Method for sealing a memory device according claim 3, **characterized by** the fact said inert atmosphere treatment (13) is made by N₂ gas.
